# EUROPÄISCHE PATENTSCHRIFT

(11) **EP 2 976 442 B1**
(45) Veröffentlichungstag und Bekanntmachung des Hinweises auf die Patenterteilung: **28.11.2018**
(21) Anmeldenummer: 14717395.9
(22) Anmeldetag: 12.03.2014
(51) Int. Cl.: C22C 38/20, C22C 38/34, C22C 38/38, C22C 38/28, C23C 30/00, C23C 28/02, C23C 2/06, C22C 38/18, C22C 38/16, C25D 7/06, C25D 5/10, C22C 38/06, C22C 38/04

(54) **VERFAHREN ZUR VERBESSERUNG DER SCHWEISSBARKEIT VON HOCHMANGANHALTIGEN STAHLBÄNDERN**
METHOD FOR IMPROVING THE WELDABILITY OF HIGH-MANGANESE-CONTAINING STEEL STRIPS
PROCÉDÉ POUR AMÉLIORER LA SOUDABILITÉ DE BANDES D'ACIER À TENEUR ÉLEVÉE EN MANGANÈSE

(30) Priorität: 21.03.2013 DE 102013005301
(43) Veröffentlichungstag der Anmeldung: 27.01.2016
(73) Patentinhaber: Salzgitter Flachstahl GmbH, 38239 Salzgitter (DE)
(72) Erfinder: KÖHLER, Kai, 31171 Nordstemme (DE); DEBEAUX, Marc, 38100 Braunschweig (DE); LUTHER, Friedrich, 30173 Hannover (DE)
(74) Vertreter: Meissner, Peter E.
(86) Internationale Anmeldenummer: PCT/DE2014/000140
(87) Internationale Veröffentlichungsnummer: WO 2014/146638

(56) Entgegenhaltungen:
- WO-A1-2007/074994
- WO-A1-2009/084793
- DE-A1-102008 005 605
- DE-A1-102009 053 260
- DE-B3-102006 039 307
- JP-A- H0 860 342
- US-A- 4 524 111
- US-A1- 2008 083 477

## Beschreibung

Die Erfindung betrifft ein Verfahren zur Verbesserung der Schweißbarkeit von hochmanganhaltigen, zinkbeschichteten Stahlbändern, die (in Gew.%) neben 6 bis 30% Mangan, bis zu 1% Kohlenstoff, bis zu 15% Aluminium, bis zu 6% Silizium, bis zu 6,5% Chrom, bis zu 4% Kupfer, sowie Zugaben von Titan und Zirkonium von insgesamt bis zu 0,7% und Niob und Vanadium von insgesamt bis zu 0,5%, Rest Eisen einschließlich unvermeidbarer stahlbegleitender Elemente enthalten können.

Stähle mit hohen Gehalten an Mangan, Aluminium und/oder Silizium, unter anderem als HSD®-Stähle (High Strength and Ductlity) bekannt, eigenen sich aufgrund ihrer günstigen Eigenschaften bezüglich Dehnung und Festigkeit für den Transportfahrzeugbau insbesondere für den Automobilbau.

Hochmanganhaltige Stähle (z.B. HSD®-Stähle) zeichnen sich im Vergleich zu üblichen Stählen durch ein deutlich geringeres spezifisches Gewicht aus, so dass der Einsatz dieser Leichtbaustähle zu einer erheblichen Gewichtsreduzierung im Karosseriebau beiträgt.

Stähle mit hohen Mangangehalten von 7 bis 27 Gew.% sind z.B. aus der DE 199 00 199 A1 bekannt und Stähle mit 9 bis 30 Gew.% Mangan aus der DE 10 2004 061 284 A1. Flachprodukte aus diesen Stählen weisen bei hohen Festigkeiten eine hohe Gleichmaßdehnung auf.

Stähle mit höheren Mangangehalten neigen jedoch zu Lochfraß und Flächenkorrosion und ohne den Zusatz von Aluminium und/oder Silizium weisen sie eine geringe Resistenz gegen wasserstoffinduzierte Spannungsrisskorrosion auf. Daher wurde bereits vorgeschlagen, auch Flachprodukte aus hochmanganhaltigen Stählen in bekannter Weise mit einem metallischen Überzug zu versehen, der den Stahl vor einem korrosiven Angriff schützt.

Bei entsprechenden Anforderungen an die Korrosionsbeständigkeit ist es bekannt, auf das zu beschichtende hochmanganhaltige Stahlband eine Korrosionsschutzschicht aus Zink oder aus einer Zinklegierung aufzubringen.

Aus der JP H08060342 ist es bekannt, die Haftungseigenschaften zwischen einem Stahlband und einer aufgedampften Zn-Mg Beschichtung dadurch zu verbessern, dass eine Zn-Fe Zwischenschicht aufgedampft wird.

Ferner ist es aus der DE 10 2008 005 605 A1 ein hochmanganhaltiges Stahlflachprodukt mit einer metallischen Zn-Fe Schutzschicht zu versehen.

Hochmanganhaltige Stahlbänder können sowohl im kalt- wie auch warmgewalzten Zustand vorliegen, wobei die Zink- oder Zinklegierungsschicht im Allgemeinen elektrolytisch oder im Schmelztauchverfahren aufgetragen wird.

Aus der DE 199 00 199 A1 ist bekannt, die Oberfläche des Flachproduktes mit Aluminium anzureichern und/oder zu beschichten. In der WO 2007/075006 A1 wird ein hochmanganhaltiger Stahl vorgeschlagen, wobei das in bekannter Weise daraus erzeugte Flachprodukt nach der letzten Schlussglühung wahlweise elektrolytisch oder durch Schmelztauchen mit einer Zinkschicht überzogen wird.

Ungelöst ist bei einer Reihe der bekannten hochmanganhaltigen Stählen bisher jedoch das Problem ihrer unzureichenden Schweißbarkeit im verzinkten Zustand, welches durch das Auftreten von flüssigmetallinduzierter Rissbildung in der Schweißzone des Werkstoffs gekennzeichnet ist.

Unter Schweißen werden im Folgenden alle Widerstands- wie auch Schmelz- oder Strahlschweißverfahren verstanden, bei denen neben dem Grundmaterial der Zinküberzug lokal verflüssigt wird.

In Folge der Wärmeeinwirkung während des Schweißens kommt es im Grundmaterial zur Infiltration der Korngrenzen durch verflüssigtes Zink aus dem Überzug. Diese Infiltration bewirkt, dass das Grundmaterial im Umfeld der Schweißzone seine Festigkeit und Duktilität in dem Maße verliert, dass die Schweißverbindung, bzw. das an die Schweißverbindung angrenzende Grundmaterial, die gestellten mechanischen Anforderungen nicht mehr erfüllt und die Gefahr des vorzeitigen Versagens der Schweißverbindung durch Rissbildung steigt. Diese Form der Spannungsrisskorrosion wird als Flüssigmetallversprödung oder "Liquid Metal Embrittlement" (LME) bezeichnet, da das korrosive Medium hier ein flüssiges Metall ist.

Zur Verbesserung der Schweißbarkeit für schmelztauchbeschichtete hochmanganhaltige Leichtbaustähle wird in der DE 10 2005 008 410 B3 vorgeschlagen, vor der Schlussglühung auf das Kaltband eine Aluminiumschicht mittels PVD (Physical Vapor Deposition) aufzutragen. Hierauf wird nach der letzten Glühung der Korrosionsschutzüberzug aufgebracht. Die infolge der Wärmebehandlung gebildete Al/Fe-Diffusionsschicht soll das Eindringen von schmelzflüssigem Zink in den Grundwerkstoff während des Schweißens und somit die Flüssigmetallversprödung verhindern. Nachteilig hierbei ist jedoch der damit verbundene verfahrensbedingte hohe Kostenaufwand.

Zur Vermeidung einer flüssigmetallinduzierten Rissbildung hochmanganhaltiger verzinkter Stähle wird in der DE 10 2009 053 260 A1 eine Glühbehandlung in einer N₂/H₂-haltigen Atmosphäre vorgeschlagen, die zur Bildung von Aluminiumnitriden auf der Stahloberfläche führt. Diese oberflächennahen Aluminiumnitridschichten sollen das Eindringen von Zink in den Werkstoff und somit eine Versprödung verhindern. Nachteilig sind hierbei die notwendigen hohen Nitriertemperaturen, die zu einer Verschlechterung der mechanischen Eigenschaften des Grundwerkstoffs führen können.

Ausgehend vom erläuterten Stand der Technik besteht die Aufgabe der Erfindung darin, unter Vermeidung der Nachteile bekannter Verfahren ein alternatives und kostengünstiges Verfahren anzugeben, mit dem es einerseits möglich ist den hochmanganhaltigen Stahl effektiv gegen Korrosion zu schützen und andererseits das Problem der flüssigmetallinduzierten Rissbildung beim Schweißen zu umgehen. Des Weiteren soll ein entsprechend beschichtetes Stahlblech bereitgestellt werden.

In Bezug auf das Verfahren wird die gestellte Aufgabe in der Weise gelöst, dass Stahlbänder, enthaltend (in Gew.%) 6 bis 30% Mangan, bis zu 1% Kohlenstoff, bis zu 15% Aluminium, bis zu 6% Silizium, bis zu 6,5% Chrom, bis zu 4% Kupfer, sowie Zugaben von Titan und Zirkonium von insgesamt bis zu 0,7% und Niob und Vanadium von insgesamt bis zu 0,5%, Rest Eisen einschließlich unvermeidbarer stahlbegleitender Elemente, die mit einer zinkenthaltenden Korrosionsschutzschicht beschichtet werden, welches dadurch gekennzeichnet ist, dass zur Verhinderung einer Flüssigmetallversprödung des Stahlbandes beim Schweißen als zinkenthaltende Korrosionsschutzschicht eine Legierung aus Zink/Mangan oder Zink/Kobalt auf das Stahlband aufgetragen wird.

Vorteilhaft weisen die Stahlbänder (Warm- oder Kaltband) einen Kohlenstoffgehalt von mindestens (in Gew.%) 0,04% und einen Silizium- und Aluminiumgehalt von mindestens je 0,05% auf, um einerseits eine erhöhte Resistenz gegen wasserstoffinduzierte Spannungsrisskorrosion zu realisieren und andererseits durch das Zusammenspiel von Mangan, Kohlenstoff, Silizium und Aluminium eine verformungsinduzierte Martensitbildung und die damit verbundene Verfestigung zu hemmen.

Überraschend hat sich bei Versuchen gezeigt, dass eine Beschichtung des Werkstoffs mit einer Schicht, die neben Zink zusätzlich Mangan oder Kobalt enthält, zusätzlich zu einem hervorragenden Korrosionsschutz einen besonders positiven Einfluss auf die Verhinderung der Flüssigmetallversprödung hat. Diese nicht erfindungsgemäße Variante wird im Weiteren als einschichtige Variante bezeichnet. Zusätzlich hierzu stellte sich heraus, dass eine flüssigmetallinduzierte Rissbildung auch dann wirkungsvoll verhindert wird, wenn auf eine primär auf das Stahlband aufgebrachte dünne Schicht aus Zink/Mangan oder Zink/Kobalt eine zinkbasierte Schicht als zweite Schicht aufgebracht wird. Diese erfindungsgemäße Variante wird im Weiteren als mehrschichtige Ausführungsvariante bezeichnet. Erfindungsgemäß erfüllt die zinkenthaltende Korrosionsschutzschicht somit insbesondere die Aufgabe einer Barriereschicht, wohingegen der eigentliche kathodische Korrosionsschutz durch die zweite, die zinkbasierte Schicht, erfolgt.

Die versprödungshemmende Wirkung der erfindungsgemäß auf das Stahlband aufzubringenden zinkenthaltenden Korrosionsschutzschicht lässt sich zum Einen auf die Bildung oberflächennaher Oxidationsprodukte während des Fügeprozesses zurückführen (z.B. auf die Bildung von Manganoxiden im Fall von Zink/Manganlegierungen). Hierdurch werden Diffusionswege des Zinks an den Korngrenzen blockiert, wodurch das Eindringen von Zink und schließlich eine Versprödung des Werkstoffs verhindert werden.

Zum Anderen führt die Auflegierung einer Zinkschicht mit Mangan oder Kobalt zu einer Schmelzpunkterhöhung der Schichten, wodurch das Aufschmelzen der Beschichtung beim Fügeprozess reduziert wird.

Zur Sicherstellung eines ausreichenden Korrosionsschutzes in Kombination mit einer die Flüssigkeitsversprödung hemmenden Wirkung ist bei der einschichtigen Variante als auch bei der erfindungsgemäßen mehrschichtigen Ausführungsvariante vorgesehen, dass der Anteil des jeweiligen Legierungselementes (in Gew.%) in der zinkenthaltenden Korrosionsschutzschicht mindestens 1% betragen sollte. Als vorteilhaft haben sich jeweilige Mindestgehalte von 5 bis 25% herausgestellt, um eine signifikante Verbesserung der Schweißbarkeit zu erreichen. Erforderlichenfalls können die Gehalte auf 50% oder mehr gesteigert werden.

Die Dicke des Überzugs kann in der einschichtigen Variante je nach Anforderung an den Korrosionsschutz zwischen 0,5 µm und 50 µm betragen. Bei elektrolytischer Verzinkung haben sich Schichtdicken von 1 bis 12 µm und bei Feuerverzinkung von 5 bis 35 µm bewährt.

Im Falle der mehrschichtigen Ausführungsvariante besteht die direkt auf das Stahlsubstrat aufgebrachte zinkenthaltende Korrosionsschutzschicht aus einer 0,1 bis 5 µm dicken Schicht die neben Zink zusätzlich Mangan oder Kobalt enthält, die die Aufgabe einer Diffusionsbarriere erfüllt und einer darauf aufgebrachten zweiten zinkbasierten Schicht, die im Wesentlichen den kathodischen Korrosionsschutz sicherstellt. Bei einer Zinklegierung als zweiter Schicht kann diese neben Zink als Hauptelement als weitere Elemente Aluminium und/oder Silizium und/oder Magnesium und/oder Eisen enthalten, um spezifischen Kundenwünschen bezüglich Aussehen der Oberfläche, Lackierbarkeit, Korrosionsschutz etc. zu genügen.

Die Dicke dieser zweiten Schicht kann je nach Anforderungen zwischen 0,5 µm und 50 µm betragen.

Die Beschichtung des hochmanganhaltigen Stahlblechs erfolgt in der einschichtigen und der mehrschichtigen Variante erfindungsgemäß elektrolytisch; es ist jedoch auch möglich, den Überzug mittels nicht erfindungsgemäßer Verfahren, wie z.B. durch Abscheidung aus der Gasphase, aufzubringen.

Das erfindungsgemäße Verfahren eignet sich gleichermaßen zur Beschichtung von Warm- oder kaltgewalzten Stahlbändern.

Die Vorteile des erfindungsgemäßen Verfahrens zeigen sich zum Einen in einer deutlich erhöhten Resistenz gegenüber einer flüssigmetallinduzierten Rissbildung im Vergleich zu einem nur mit Zink überzogenen hochmanganhaltigen Stahl. Zum Anderen lässt sich das Aufbringen der erfindungsgemäßen Überzüge bei der ein- oder mehrschichtigen Variante kostengünstig mit bekannten und vorhandenen großtechnischen Aggregaten durch Elektrolyse, oder mittels nicht erfindungsgemäßer Verfahren wie dem Abscheiden aus der Gasphase (z.B. PVD) realisieren.

### Beschreibung eines Ausführungsbeispiels:

Auf einer aus der DE 10 2004 061 284 A1 bekannten Bandgießanlage wurde ein Stahl der Zusammensetzung X70Mn-Al-Si-15-2,5-2,5, Rest Eisen einschließlich unvermeidbarer stahlbegleitender Elemente zu einem Dünnband vergossen und dann zu einem Warmband gewalzt. Anschließend wurde das Warmband in üblicher Weise gebeizt, kaltgewalzt und geglüht. Danach wurde das Band gereinigt sowie einer Aktivierung der Oberfläche (Dekapierung) unterzogen, bevor es mit einer erfindungsgemäßen zinkenthaltenden Korrosionsschutzschicht und einer zinkbasierten zweiten Schicht elektrolytisch beschichtet wurde (mehrschichtige Ausführungsvariante).

Die auf das Stahlband aufgebrachten zinkenthaltenden Korrosionsschutzschichten wiesen bei jeweils 12 Proben ein Zink/Mangan-Verhältnis (in Gew.%) von 77/23, 64/36, 30/70 und 40/60 und bei jeweils 5 Proben ein Zink/Kobalt-Verhältnis (in Gew.%) von 28/72, 89/11 und 91/9 auf. Die Schichtdicken betrugen in der einschichtigen Ausführungsvariante zwischen 1 und 5 µm. In der mehrschichtigen Ausführungsvariante betrug die Dicke der ersten Schicht zwischen 0,5 und 1 µm und die Dicke der zweiten Schicht zwischen 1 und 4 µm. Zur Überprüfung der Anfälligkeit gegenüber flüssigmetallinduzierter Rissbildung wurden die Proben im Widerstandspunktschweißverfahren gefügt.

Alle 48 Proben mit Zink/Mangan-Schichten und auch alle 15 Schweißproben mit Zink/KobaltSchichten waren rissfrei. Die Ergebnisse der Schweißversuche sind auch in den Tabellen 1 und 2 zusammengestellt.

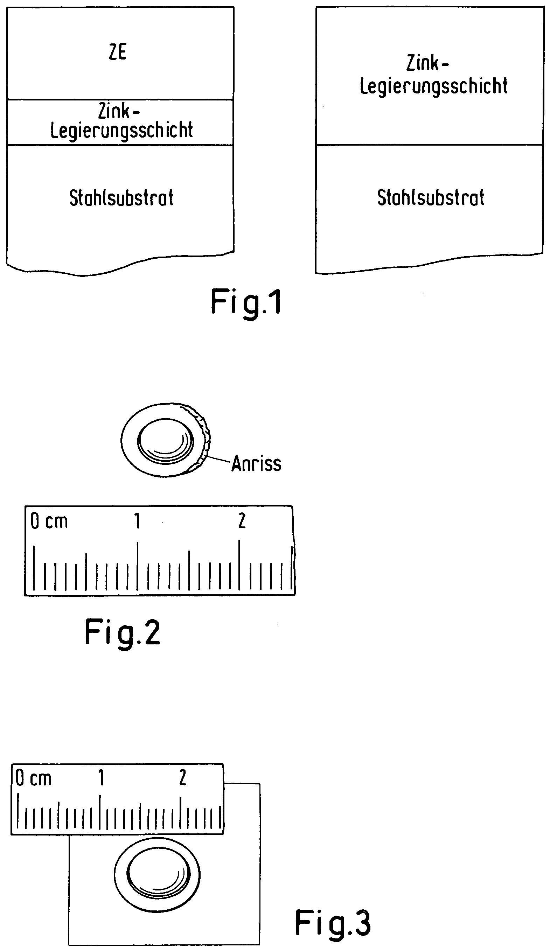

In **Figur 1** ist im linken Teilbild eine erfindungsgemäße Ausführungsvariante mit einem mehrschichtigen Aufbau des Korrosionsschutzüberzugs schematisch dargestellt. Auf das hochmanganhaltige Stahlsubstrat wurde zuerst elektrolytisch eine erfindungsgemäße zinkenthaltende Korrosionsschutzschicht und anschließend elektrolytisch eine zweite Schicht aus Zink (ZE) aufgebracht. Die Dicke der zinkenthaltenden Korrosionsschutzschicht kann bei dieser Ausführungsvariante zwischen 0,1 µm und 50 µm betragen, wohingegen die Dicke der zinkbasierten Schicht zwischen 0,5 µm und 50 µm betragen kann.

Das rechte Teilbild in **Figur 1** zeigt eine zweite Variante mit einem einschichtigen Aufbau. Bei einem solchen Aufbau wird auf das hochmanganhaltige Stahlsubstrat eine zinkenthaltende Korrosionsschutzschicht in einer Dicke zwischen 0,5 µm und 50 µm aufgetragen.

Die **Figuren 2 und 3** zeigen Bilder von widerstandspunktgeschweißten Proben.

**Figur 2** zeigt eine übliche zinkbeschichtete (ZE) hochmanganhaltige Stahlprobe, die im Widerstandspunktschweißverfahren gefügt wurde. Die Zinkschichtdicke beträgt ca. 3,5 µm. Diese Probe zeigt einen flüssigmetallinduzierten Anriss in der Wärmeeinflusszone.

**Figur 3** zeigt eine hochmanganhaltige Stahlprobe, die elektrolytisch mit einer erfindungsgemäßen 23 Gew.% Mangan enthaltenden Zink-Legierungsschicht in einer Dicke von 2 µm beschichtet und anschließend im Widerstandspunktschweißverfahren gefügt wurde. Die Probe weist vollständige Rissfreiheit auf.

**Tabelle 1: Ergebnisse von Schweißtests an Blechen mit Zink/Mangan-Korrosionsschutzüberzügen unterschiedlicher Zusammensetzung**

| Zn/Mn Verhältnis [Gew. %] | 77/23 | 64/36 | 30/70 | 40/60 |
|---|---|---|---|---|
| Riss in Schweißprobe: | | | | |
| 1 | nein | nein | nein | nein |
| 2 | nein | nein | nein | nein |
| 3 | nein | nein | nein | nein |
| 4 | nein | nein | nein | nein |
| 5 | nein | nein | nein | nein |
| 6 | nein | nein | nein | nein |
| 7 | nein | nein | nein | nein |
| 3 | nein | nein | nein | nein |
| 9 | nein | nein | nein | nein |
| 10 | nein | nein | nein | nein |
| 11 | nein | nein | nein | nein |
| 12 | nein | nein | nein | nein |

**Tabelle 2: Ergebnisse von Schweißtests an Blechen mit Zink/Kobalt-Korrosionsschutzüberzügen unterschiedlicher Zusammensetzung**

| Zn/Co Verhältnis in der Legierung [Gew. %] | 28/72 | 89/11 | 91/9 |
|---|---|---|---|
| Riss in Schweißprobe: | | | |
| 1 | nein | nein | nein |
| 2 | nein | nein | nein |
| 3 | nein | nein | nein |
| 4 | nein | nein | nein |
| 5 | nein | nein | nein |

## Patentansprüche

1. Verfahren zur Verbesserung der Schweißbarkeit von hochmanganhaltigen Stahlbändern, enthaltend (in Gew.%) 6 bis 30 % Mangan, bis zu 1 % Kohlenstoff, bis zu 15 % Aluminium, bis zu 6 % Silizium, bis zu 6,5 % Chrom, bis zu 4 % Kupfer, sowie Zugaben von Titan und Zirkonium von insgesamt bis zu 0,7 % und Niob und Vanadium von insgesamt bis zu 0,5 %, Rest Eisen und schmelzungsbedingte Verunreinigungen, die mit einer zinkenthaltenden Korrosionsschutzschicht beschichtet werden,
**dadurch gekennzeichnet,**
**dass** zur Verhinderung einer Flüssigmetallversprödung beim Schweißen eine zinkenthaltende Korrosionsschutzschicht in einer Dicke von 0,1 µm bis 5 µm als Legierung aus Zink/Mangan oder Zink/Kobalt elektrolytisch aufgetragen wird, wobei der Anteil des jeweiligen Legierungselementes mindestens 1 % beträgt, und dass auf die erste zinkenthaltende Korrosionsschutzschicht eine zweite zinkbasierte Schicht, in einer Dicke zwischen 0,5 µm und 50 µm, insbesondere zwischen 1 µm und 12 µm, elektrolytisch aufgetragen wird, wobei die zweite zinkbasierte Schicht neben Zink als weitere Elemente Aluminium und/oder Silizium und/oder Magnesium und/oder Eisen enthält.

2. Verfahren nach Anspruch 1,
**dadurch gekennzeichnet,**
**dass** der Zinkgehalt der ersten zinkenthaltenen Korrosionsschutzschicht 30 - 99 Gew. %, insbesondere 75 - 95 Gew. %, beträgt.

## Claims

1. Method for improving the weldability of high manganese-containing steel bands, containing (in % by weight) 6 to 30% manganese, up to 1% carbon, up to 15% aluminium, up to 6% silicon, up to 6.5% chromium, up to 4% copper, and additions of titanium and zirconium of a total of up to 0.7% and niobium and vanadium of a total up to 0.5%, remainder iron and smelting-induced impurities, which are coated with a zinc-containing corrosion protection layer,
**characterised**
**in that** for preventing a liquid metal embrittlement during welding, a zinc-containing corrosion protection layer in a thickness of 0.1 µm up to 5 µm is applied electrolytically as alloy of zinc/manganese or zinc/cobalt, wherein the proportion of the respective alloy element is at least 1%, and in that on the first zinc-containing corrosion protection layer a second zinc-based layer is applied, in a thickness between 0.5 µm and 50 µm, in particular between 1 µm and 12 µm, wherein in addition to zinc, the second zinc-based layer contains as further elements aluminium and/or silicon and/or magnesium and/or iron.

2. Method according to claim 1,
**characterised**
**in that** the zinc content of the first zinc-containing corrosion protection layer is 30 - 99 percent by weight, in particular 75 - 95 percent by weight.

## Revendications

1. Procédé pour améliorer la soudabilité de bandes d'acier à teneur élevée en manganèse, contenant (en % en poids) 6 à 30 % de manganèse, jusqu'à 1 % de carbone, jusqu'à 15 % d'aluminium, jusqu'à 6 % de silicium, jusqu'à 6,5 % de chrome, jusqu'à 4 % de cuivre, ainsi que des additions de titane et de zirconium allant jusqu'à un total de 0,7 % et de niobium et de vanadium allant jusqu'à un total de 0,5 %, le reste étant du fer et des impuretés dues à la fusion, qui sont revêtues d'une couche anticorrosion contenant du zinc, **caractérisé en ce**
**qu'**une couche anticorrosion contenant du zinc d'une épaisseur de 0,1 µm à 5 µm est appliquée électrolytiquement en tant qu'alliage zinc/manganèse ou zinc/cobalt pour empêcher une fragilité du métal liquide lors du soudage, dans lequel la teneur de l'élément d'alliage respectif est d'au moins 1 %, et
**qu'**une deuxième couche à base de zinc, d'une épaisseur entre 0,5 µm et 50 µm, en particulier entre 1 µm et 12 µm, est appliquée électrolytiquement sur la première couche anticorrosion contenant du zinc, dans lequel la deuxième couche à base de zinc contient en plus du zinc en tant qu'autres éléments de l'aluminium et/ou du silicium et/ou du magnésium et/ou du fer.

2. Procédé selon la revendication 1,
**caractérisé en ce**
**que** la teneur en zinc de la première couche anticorrosion contenant du zinc est de 30 - 99 % en poids, en particulier de 75 - 95 % en poids.
